# EUROPEAN PATENT SPECIFICATION

(11) **EP 3 263 575 B1**
(45) Date of publication and mention of the grant of the patent: **10.07.2019**
(21) Application number: 16197402.7
(22) Date of filing: 04.11.2016
(51) Int. Cl.: C07F 7/24, H01L 51/42

(54) **A HIGHLY STABLE TWO-DIMENSIONAL PEROVSKITE MATERIAL AND THE USE THEREOF**
HOCHSTABILES ZWEIDIMENSIONALES PEROWSKITMATERIAL UND VERWENDUNG DAVON
MATÉRIAU EN PEROVSKITE BIDIMENSIONNEL HAUTEMENT STABLE ET SON UTILISATION

(30) Priority: 27.06.2016 CN 201610482833
(43) Date of publication of application: 03.01.2018
(73) Proprietor: North China Electric Power University, Beijing 102206 (CN)
(72) Inventor: Dai, Songyuan, Beijing, Beijing 102206 (CN); Pan, Xu, Beijing, Beijing 102206 (CN); Zheng, Haiying, Beijing, Beijing 102206 (CN); Ye, Jiajiu, Beijing, Beijing 102206 (CN); Ma, Shuang, Beijing, Beijing 102206 (CN); Tan, Zhan'ao, Beijing, Beijing 102206 (CN); Yao, Jianxi, Beijing, Beijing 102206 (CN); Zhang, Bing, Beijing, Beijing 102206 (CN)
(74) Representative: Epping - Hermann - Fischer

(56) References cited:
- CN-A- 104 795 501
- CONSTANTINOS C. STOUMPOS ET AL: "Ruddlesden-Popper Hybrid Lead Iodide Perovskite 2D Homologous Semiconductors", CHEMISTRY OF MATERIALS, vol. 28, no. 8, 26 April 2016 (2016-04-26) , pages 2852-2867, XP055353950, US ISSN: 0897-4756, DOI: 10.1021/acs.chemmater.6b00847
- MAJID SAFDARI ET AL: "Layered 2D alkyldiammonium lead iodide perovskites: synthesis, characterization, and use in solar cells", JOURNAL OF MATERIALS CHEMISTRY A: MATERIALS FOR ENERGY AND SUSTAINABILITY, vol. 4, no. 40, 1 January 2016 (2016-01-01), pages 15638-15646, XP055353952, GB ISSN: 2050-7488, DOI: 10.1039/C6TA05055G -& Majid Safdari ET AL: "Supplementary Information for Layered 2D Alkyldiammonium Lead Iodide Perovskites: Synthesis, Characterization, and Use in Solar Cells", Electronic Supplementary Material (ESI) for Journal of Materials Chemistry A, 15 September 2016 (2016-09-15), pages 1-11, XP055353945, Retrieved from the Internet: URL:http://www.rsc.org/suppdata/c6/ta/c6ta 05055g/c6ta05055g1.pdf [retrieved on 2017-03-13]
- ZHONGMIN ZHOU ET AL: "The fabrication of formamidinium lead iodide perovskite thin films via organic cation exchange", CHEMICAL COMMUNICATIONS - CHEMCOM., vol. 52, no. 19, 1 January 2016 (2016-01-01), pages 3828-3831, XP055354284, ISSN: 1359-7345, DOI: 10.1039/C5CC09873D -& Zhongmin Zhou ET AL: "Electronic Supplementary Information Fabrication of formamidinium lead iodide perovskite thin films via organic cation exchange", Electronic Supplementary Material (ESI) for ChemComm, 4 February 2016 (2016-02-04), pages 1-7, XP055354285, Retrieved from the Internet: URL:http://www.rsc.org/suppdata/c5/cc/c5cc 09873d/c5cc09873d1.pdf [retrieved on 2017-03-13]

## Description

### Field of the invention

The present invention belongs to the technical field of perovskite solar cells, and particularly relates to a highly stable two-dimensional perovskite material and use.

### Background

The advent of perovskite solar cells in 2009 has attracted extensive attention of the global researchers, and led to a research upsurge for a new solar cell. The solar cell based on organometal halide perovskite has caused a considerable concern due to its advantages such as excellent photoelectric properties, high absorption coefficient, various and easy manufacture processes and low cost and so on, and represents an emerging photovoltaic technology.

Although the efficiency of the perovskite solar cell is continuously increasing, there is still a need to consider improving the encapsulation technology of CH₃NH₃PbX₃ perovskite cell, solving its stability problem, extending the cell life and thereby achieving industrialized application, because perovskites are sensitive to moisture and oxygen and would be subjected to photolysis upon prolonged exposure in the sun, and so on.

Organic/inorganic perovskite has a general formula of (RNH₃)₂(CH₃NH₃)ₙ₋₁Pbₙ₊₁X₃ₙ₊₁, wherein RNH3⁺ is an organic amine cation, which is a layered 2D perovskite material when n ≥2. As the number of the inorganic layers is increased, the position of the UV-vis absorption peak of the 2D perovskite material is gradually red shifted, the energy gap and exciton binding energy are gradually reduced, the electroconductive property is gradually enhanced and in the visible light region, and the light absorption is stronger and the photoluminescence is strong. Although the two-dimensional perovskite material has a lower efficiency, as compared to conventional perovskite materials, it has a very high stability and moisture-resistance capability, can replace the conventional perovskite material very well, and achieve a stable and long-term industrial application under the premise of a high efficiency, and therefore has a very high research value and an enormous development prospect.

CN 104795501 A relates to a perovskite solar cell and a method for manufacturing the same. The perovskite solar cell comprises an FTO (fluorine-doped tin oxide) transparent conducting glass substrate, an electron transport layer, a light absorption layer, a hole transport layer and a metal electrode. The light absorption layer is made of (C₆H₅CH₂CH₂NH₃)₂(CH₃NH₃)ₙ₋₁PbₙI_{3*n+1} (the n is equal to 1 or 2) materials which are of two-dimensional layered structures. The perovskite solar cell and the method have the advantages that the layered perovskite light absorption layer is manufactured by the aid of a spin coating process, the method is simple and is excellent in film-forming property, the materials of the light absorption layer can be changed along with the layer number n, gaps of the materials can be adjusted, and the materials are excellent in chemical stability and still can keep the excellent layered structures without chemical decomposition after being exposed at high air humidity (50-80%) for 30 days, solar cell prototype devices with excellent and stable performance can be obtained, and the perovskite solar cell and the method are favorable for promoting perovskite solar cell commercialization progress.

Constantinos C. Stoumpos et al., "Ruddlesden-Popper Hybrid Lead Iodide Perovskite 2D Homologous Semiconductors", Chemistry of Materials 2016 28 (8), 2852-2867, discloses the large scale synthesis, crystal structure, and optical characterization of the 2D (CH₃(CH₂)₃NH₃)₂(CH₃NH₃)ₙ₋₁PbₙI₃ₙ₊₁ (n = 1, 2, 3, 4, ∞) perovskites, a family of layered compounds with tunable semiconductor characteristics. These materials consist of well-defined inorganic perovskite layers intercalated with bulky butylammonium cations that act as spacers between these fragments, adopting the crystal structure of the Ruddlesden-Popper type.

Majid Safdari et al., "Layered 2D alkyldiammonium lead iodide perovskites: synthesis, characterization, and use in solar cells", J. Mater. Chem. A, 2016, 4, 15638-15646 disclaoses the synthetic route and properties of three 2D hybrid organic/inorganic lead iodide perovskite materials. The 2D perovskites were synthesized from the reaction between PbI2 and the di-cations of 1,4-diaminobutane, 1,6-diaminohexane, and 1,8-diaminooctane. The resulting products were [NH₃(CH₂)₄NH₃]PbI₄, [NH₃(CH₂)₆NH₃]PbI₄, and [NH₃(CH₂)₈NH₃]PbI₄. The 2D perovskite materials were investigated as light absorbing materials in solid state solar cells.

Zhongmin Zhou, "The fabrication of formamidinium lead iodide perovskite thin films via organic cation exchange", Chem. Commun., 2016, 52, 3828-3831 discloses the production of high-quality formamidinium lead iodide (FAPbI3) perovskite thin films via organic cation exchange. With ammonia lead iodide (NH4PbI3) as the starting material, the NH4+ in NH4PbI3 could be gradually substituted by FA+ in formamidine acetate (FA-Ac) and simultaneously transformed to the pure phase α-FAPbI3 at elevated temperature.

### Summary of the invention

The present invention provides a highly stable two-dimensional perovskite material and the use thereof, with the particular technical solutions as follows.

A highly stable two-dimensional perovskite material, having a general formula of (A)₂(CH(NH₂)₂)ₙ₋₁PbₙI₃ₙ₊₁, wherein A is (CH₃)₂NH₂, C₆H₅CH₂NH₃, CHONH₃, NH₄, H₃NCH₂CH₂CH₂NH₃ or H₃NCH₂CH₂CH₂CH₂NH₃; and n = 3, 5, 7, 9, 11.

Preferably, n=9.

Use of the highly stable two-dimensional perovskite material as described above in the manufacture of a perovskite solar cell.

The perovskite solar cell manufactured using the highly stable two-dimensional perovskite material as described herein has an efficiency decrease of less than 0.5% after being exposed under a condition of larger than 90% humidity for more than 20 days.

The present invention has the following advantageous effects.

As compared to the conventional CH₃NH₃PbI₃ or CH(NH₂)₂PbI₃ perovskite material, the material of the present invention has a higher stability and moisture-resistance capability with the red-shifted ultraviolet-visible light adsorption and photoluminescence peaks and reduced energy gap. A best performance is achieved for (A)₂(CH(NH₂)₂)ₙ₋₁PbₙI₃ₙ₊₁ when n=9, wherein the open circuit voltage is 1.03V, the current density is 20.54 mA cm⁻², the fill factor is 71.71% and the optimum efficiency reaches 15.17%; there is no obvious decrease in the efficiency when being exposed to a condition of larger than 90% humidity for longer than 20 days and the XRD peak shows that no significant decomposition occurs in the perovskite membrane, illustrating that it has a very high stability in humidity, can replace the conventional perovskite material, achieves long-term, stable and efficient operation for the perovskite solar cell and brings a promise for its industrialization.

### Brief description of the figure

Fig.1 is a SEM cross-section of the two-dimensional perovskite material, (A)₂(CH(NH₂)₂)ₙ₋₁PbₙI₃ₙ₊₁ (n = 3, 5, 7, 9 and 11) manufactured by the present invention, wherein (a)∼(e) correspond to n=3∼11 in sequence;
Fig. 2 is a *J-V* curve of the two-dimensional perovskite (CHONH₃)₂(CH(NH₂)₂)₈Pb₉I₂₈ solar cell manufactured in Example 2 and the conventional CH(NH₂)₂PbI₃ perovskite solar cell;
Fig. 3 is a ultraviolet-visible light absorption spectrum of the two-dimensional perovskite material (CHONH₃)₂(CH(NH₂)₂)₈Pb₉I₂₈ manufactured in Example 2;
Fig. 4 is a photoluminescence spectrum of the two-dimensional perovskite material (CHONH₃)₂(CH(NH₂)₂)₈Pb₉I₂₈ manufactured in Example 2 and the conventional CH(NH₂)₂PbI₃ perovskite material;
Fig. 5 is a graph of the change in the normalized efficiency of (CHONH₃)₂(CH(NH₂)₂)₈Pb₉I₂₈ solar cell manufactured in Example 2 and the conventional CH(NH₂)₂PbI₃ perovskite based photovoltaic cell when placed under a condition of high humidity;
Fig. 6 is a XRD pattern of (CHONH₃)₂(CH(NH₂)₂)₈Pb₉I₂₈ manufactured in Example 2 and the conventional CH(NH₂)₂PbI₃ perovskite membrane before or after placed under a condition of high humidity, wherein pattern (a) corresponds to (CHONH₃)₂(CH(NH₂)₂)₈Pb₉I₂₈, and pattern (b) corresponds to the conventional CH(NH₂)₂PbI₃ perovskite membrane.

### Detailed description of the invention

Hereinafter, the present invention is further illustrated, but is not limited in any way.

### Configuration of a two-dimensional perovskite solar cell

FTO glass (1.5 cm × 2.0 cm) was etched away for 2 mm with zinc powder and 4 M hydrochloric acid. The substrate was firstly cleaned ultrasonically with a detergent, then rinsed with ultrapure water and ethanol for 3 times respectively, and oven-dried on a flattening oven. A 20 - 30 nm TiO₂ densified layer was deposited on the cleaned FTO glass at 450°C using a spray pyrolysis method with air as the carrier gas, and the precursor solution was 0.6 mL tetraisopropyl titanate and 0.4 mL acetylacetone (the solvent was 7 mL anhydrous isopropyl alcohol). 30 nm Dyesol was diluted with ethanol with a mass ratio of 1:5.5 to obtain a nano-slurry. Then the slurry was spin-coated at 4000 rpm, 2000 rpm s⁻¹ for 20 s. The mesoporous TiO₂ coating was deposited on the substrate, placed on a flattening oven and annealed under a high temperature for 3 h, and the temperature was raised from room temperature to 510°C. In a flowing air glove box, 1.3 M Pb²⁺ perovskite precursor solution was spin-coated at 1000 rpm, 200 rpm s⁻¹ for 20 s, followed by 6000 rpm, 2000 rpm s⁻¹ for 30 s, and 120 µL chlorobenzene was added dropwise on the spun substrate just 20 s before the end of the spin-coating (i.e. the spin-coating process was further carried out for 20s after the chlorobenzene was added dropwise on the spun substrate). Then, the substrate was heated for 60 min on a flattening oven of 100°C to obtain a light-absorbing layer. 1.3 M Pb²⁺ precursor solution CH(NH₂)₂PbI₃ and (A)₂(CH(NH₂)₂)ₙ₋₁PbₙI₃ₙ₊₁(n = 1, 3, 5, 7, 9, 11 or AI:CH(NH₂)₂I = 1:1, 1:2, 1:3, 1:4, 1:5) were prepared by the following process: dissolving the powders with a corresponding ratio in an anhydrous DMF solvent and stirring at 70°C for 30 min. After cooling to room temperature, a solution of the hole transport material (HTM) spiro-OMeTAD (obtained by dissolving 73 mL spiro-OMeTAD, lithium salt, TBP and cobalt (III) salt in chlorobenzene) was spin-coated on the perovskite layer at 3000 rpm for 30 s. Finally, 60 nm of gold was thermally evaporated under vacuum on the HTM layer. The as-described semi-finished product was placed again in a drying oven and stored, yielding the two-dimensional perovskite solar cell.

### Example 1

1.3 M Pb²⁺ perovskite precursor solution was formulated in DMF with a ratio of CHONH₃I:CH(NH₂)₂I :PbI₂=2:2:3 (n=3), and stirred at 70°C for 30 min, which was spin-coated in a flowing air glove box at 1000 rpm, 200 rpm s⁻¹ for 20 s, followed by 6000 rpm, 2000 rpm s⁻¹ for 30 s, and 120 µL chlorobenzene was added dropwise on the spun substrate 20 s before the end of the spin-coating. Then, the substrate was heated for 60 min on a flattening oven of 100°C. Other steps were performed as described in "Configuration of the two-dimensional perovskite solar cell" section to obtain the two-dimensional perovskite solar cell (CHONH₃)₂(CH(NH₂)₂)₂Pb₃I₇ (n=3). The efficiency of the cell reaches 5.38%.

### Example 2

1.3 M Pb²⁺ perovskite precursor solution was formulated in DMF with a ratio of CHONH₃I:CH(NH₂)₂I :PbI₂=2:8:9 (n=9), and stirred at 70°C for 30 min, which was spin-coated in a flowing air glove box at 1000 rpm, 200 rpm s⁻¹ for 20 s, followed by 6000 rpm, 2000 rpm s⁻¹ for 30 s, and 120 µL chlorobenzene was added dropwise on the spinning substrate 20 s before the end of the spin-coating. Then, the substrate was heated for 60 min on a flattening oven of 100°C. Other steps were performed as described in "Configurationof the two-dimensional perovskite solar cell" section to obtain the two-dimensional perovskite solar cell (CHONH₃)₂(CH(NH₂)₂)₈Pb₉I₂₈ (n=9). The efficiency of the cell reaches 15.17%.

Table 1 is the comparison results of photovoltaic parameters for CH(NH₂)₂PbI₃ and (A)₂(CH(NH₂)₂)ₙ₋₁PbₙI₃ₙ₊₁ (n = 9) based perovskite solar cell manufactured in the present example. As can be seen from the table, under the same experiment conditions, the conventional CH(NH₂)₂PbI₃ based solar cell has an efficiency of 16.00%, while the two-dimensional perovskite (A)₂(CH(NH₂)₂)ₙ₋₁PbₙI₃ₙ₊₁ (n = 9) solar cell herein has an efficiency only slightly lower than the conventional cell, which can also reach 15.17%, but is better than the conventional perovskite solar cell in terms of other properties.

**Table 1 Comparison results of photovoltaic parameters for CH(NH₂)₂PbI₃ based solar cell and (A)₂(CH(NH₂)₂)ₙ₋₁PbₙI₃ₙ₊₁ (n = 9) based perovskite solar cell manufactured in the present example**

| Device | *J*_{SC} | *V*_{OC} | FF | PCE |
|---|---|---|---|---|
| | (mA/cm²) | (V) | (%) | (%) |
| CH(NH₂)₂PbI₃ | 21.22 | 1.03 | 73.75 | 16.00 |
| n=9 | 20.54 | 1.03 | 71.71 | 15.17 |

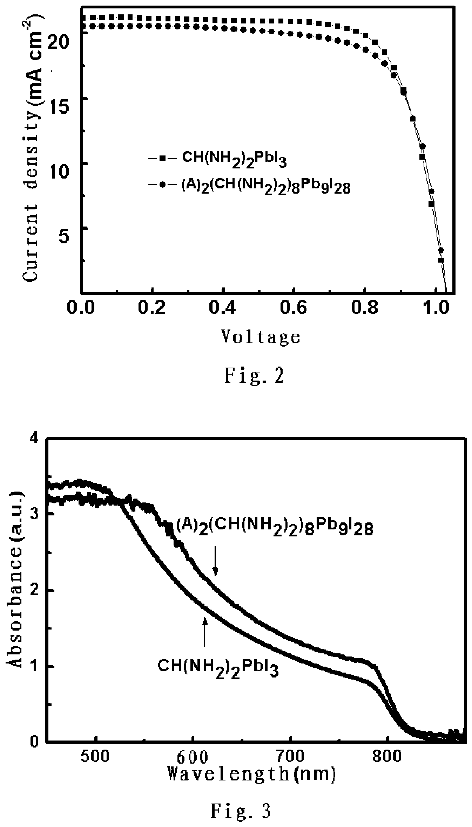

Fig. 2 is a *J-V* curve of the two-dimensional perovskite (CHONH₃)₂(CH(NH₂)₂)₈Pb₉I₂₈ solar cell manufactured in the present example and the conventional CH(NH₂)₂PbI₃ perovskite solar cell. As can be seen from the figure, the two-dimensional perovskite solar cell has a normal photovoltaic performance close to that of the conventional CH(NH₂)₂PbI₃ based solar cell, and the incorporation of A site does not change the photovoltaic performance of the cell.

Fig. 3 is a ultraviolet-visible light absorption spectrum of the two-dimensional perovskite material (CHONH₃)₂(CH(NH₂)₂)₈Pb₉I₂₈ manufactured in the present example. As can be seen from the figure, the ultraviolet-visible light absorption of the two-dimensional perovskite (CHONH₃)₂(CH(NH₂)₂)₈Pb₉I₂₈ is red-shifted and the absorption spectrum of the solar cell is broaden when compared to the conventional CH(NH₂)₂PbI₃ membrane.

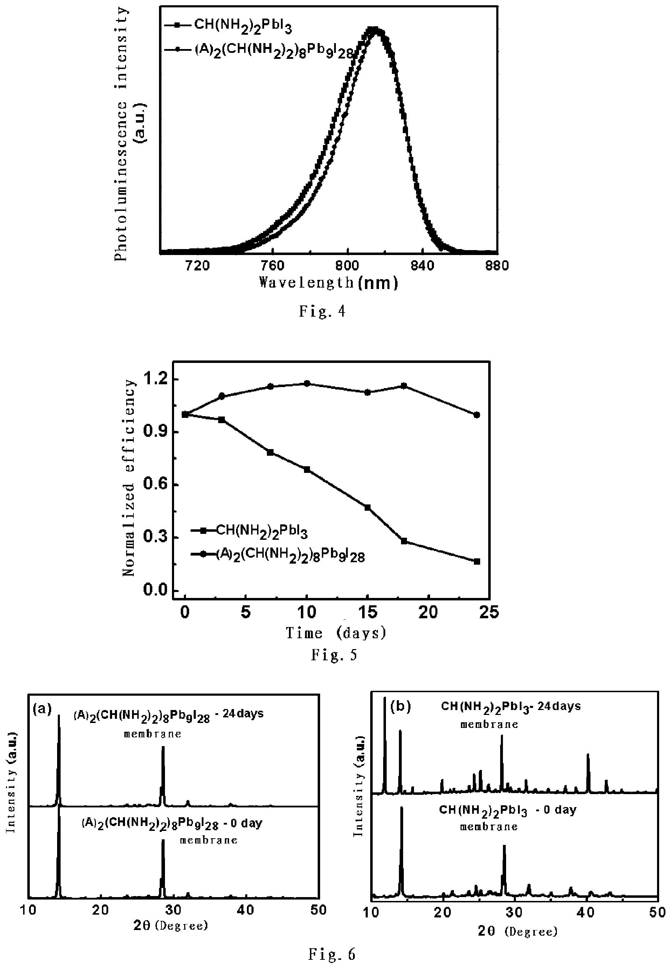

Fig. 4 is a photoluminescence spectrum of the two-dimensional perovskite (CHONH₃)₂(CH(NH₂)₂)₈Pb₉I₂₈ manufactured in the present example and the conventional CH(NH₂)₂PbI₃ perovskite material. As can be seen from the figure, the photoluminescence of the two-dimensional perovskite (CHONH₃)₂(CH(NH₂)₂)₂Pb₉I₂₈ membrane is red-shifted when compared to the conventional CH(NH₂)₂PbI₃ membrane, which corresponds to the red-shifted ultraviolet-visible light absorption in Fig. 3.

Fig. 5 is a graph of the change in the normalized efficiency of (CHONH₃)₂(CH(NH₂)₂)₈Pb₉I₂₈ solar cell manufactured in the present example and the conventional CH(NH₂)₂PbI₃ perovskite based photovoltaic cell when placed under a condition of high humidity. As can be seen from the figure, when compared to the conventional CH(NH₂)₂PbI₃ perovskite based photovoltaic cell, the (CHONH₃)₂(CH(NH₂)₂)₈Pb₉I₂₈ two-dimensional perovskite solar cell shows a very high humidity-resistance capability with 0.5% decrease in the efficiency after being exposed to a condition of larger than 90% humidity for 24 days. And the stability is very high, while the efficiency of the conventional perovskite is dramatically decreased.

Fig. 6 is a XRD pattern of (CHONH₃)₂(CH(NH₂)₂)₈Pb₉I₂₈ manufactured in the present example in contrast to the conventional CH(NH₂)₂PbI₃ perovskite membrane before or after placed under a condition of high humidity. As can be seen from the figure, when compared to the conventional CH(NH₂)₂PbI₃ perovskite based solar cell, the (CHONH₃)₂(CH(NH₂)₂)₈Pb₉I₂₈ two-dimensional perovskite solar cell presents a very high humidity-resistance capability with no significant change in the XRD pattern and no decomposition in the membrane after disposed under a condition of larger than 90% humidity for 24 days. While the membrane of the conventional perovskite is decomposed significantly, and many miscellaneous peaks and significant PbI₂ peak appear.

### Example 3

1.3 M Pb²⁺ perovskite precursor solution was formulated in DMF with a ratio of C₆H₅CH₂NH₃I:CH(NH₂)₂I :PbI₂=2:8:9 (n=9) and stirred at 70°C for 30 min, which was spin-coated in a flowing air glove box at 1000 rpm, 200 rpm s⁻¹ for 20 s, followed by 6000 rpm, 2000 rpm s⁻¹ for 30 s, and 120 µL chlorobenzene was added dropwise on the spun substrate 20 s before the end of the spin-coating. Then, the substrate was heated for 60 min on a flattening oven of 100°C. Other steps were performed as described in "Constitution of the two-dimensional perovskite solar cell" section to obtain the two-dimensional perovskite solar cell (C₆H₅CH₂NH₃)₂(CH(NH₂)₂)₈Pb₉I₂₈ (n=9). The efficiency of the cell reaches 14.40%.

### Example 4

1.3 M Pb²⁺ perovskite precursor solution was formulated in DMF with a ratio of IH₃NCH₂CH₂CH₂NH₃I:CH(NH₂)₂I :PbI₂=1:8:9 (n=9) and stirred at 70°C for 30 min, which was spin-coated in a flowing air glove box at 1000 rpm, 200 rpm s⁻¹ for 20 s, followed by 6000 rpm, 2000 rpm s⁻¹ for 30 s, and 120 µL chlorobenzene was added dropwise on the spinning substrate 20 s before the end of the spin-coating. Then, the substrate was heated for 60 min on a flattening oven of 100°C. Other steps were performed as described in "Constitution of the two-dimensional perovskite solar cell" section to obtain the two-dimensional perovskite solar cell (H₃NCH₂CH₂CH₂NH₃)₂(CH(NH₂)₂)₈Pb₉I₂₈ (n=9). The efficiency of the cell reaches 8.24%.

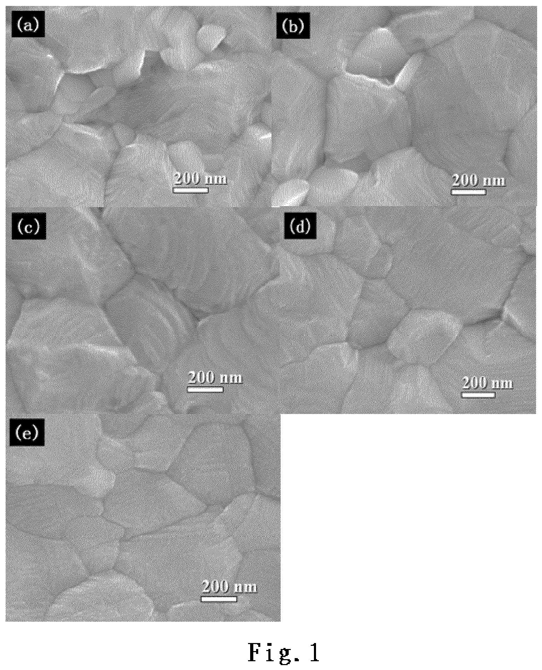

Fig.1 is a SEM cross-section of the two-dimensional perovskite material (A)₂(CH(NH₂)₂)ₙ₋₁PbₙI₃ₙ₊₁ (n = 3, 5, 7, 9 and 11) manufactured by the present invention, wherein (a)∼(e) correspond to n=3∼11 in sequence. As can be seen from the figure, (A)₂(CH(NH₂)₂)ₙ₋₁PbnI₃ₙ₊₁ is grown into a two-dimensional structure in a sheet form, wherein the smaller n is, the more significant the sheet effect is, which is obviously different from the conventional perovskite.

## Claims

1. A highly stable two-dimensional perovskite material, wherein the two-dimensional perovskite material has a general formula of (A)₂(CH(NH₂)₂)ₙ₋₁Pb₃ₙ₊₁, wherein A is (CH₃)₂NH₂, C₆H₅CH₂NH₃, CHONH₃, NH₄, H₃NCH₂CH₂CH₂NH₃ or H₃NCH₂CH₂CH₂CH₂NH₃; and wherein n = 3, 5, 7, 9, 11.

2. The highly stable two-dimensional perovskite material according to claim 1, wherein n=9.

3. Use of the highly stable two-dimensional perovskite material according to any one of claims 1-2 in the manufacture of a perovskite solar cell.

4. Use according to claim 3, wherein the manufactured perovskite solar cell has an efficiency decrease of less than 0.5% when being exposed to a condition of humidity larger than 90% for more than 20 days.

## Patentansprüche

1. Hochstabiles, flächiges Perowskit-, wobei das flächige Perowskit-Material eine allgemeine Formel (A)₂(CH(NH₂)₂)ₙ₋₁PBₙI₃ₙ₊₁ hat, worin A (CH₃)₂NH₂, C₆H₅CH₂NH₃, CHONH₃, NH₄, H₃NCH₂CH₂NH₃ oder H₃NCH₂CH₂CH₂CH₂NH₃ ist; und worin n = 3, 5, 7, 9, 11 ist.

2. Hochstabiles, flächiges Perowskit-Material nach Anspruch 1, wobei n = 9 ist.

3. Verwendung des hochstabilen, flächigen Perowskit-Materials nach einem der Ansprüche 1 - 2 in der Herstellung einer Perowskit-Solarzelle.

4. Verwendung nach Anspruch 3, wobei die hergestellte Perowskit-Solarzelle eine Leistungsfähigkeitsabnahme von weniger als 0,5 % hat, wenn sie mehr als 20 Tage lang einer Feuchtigkeitsbedingung von über 90 % ausgesetzt wird.

## Revendications

1. Matériau de pérovskite bidimensionnel à haute solidité, sachant que le matériau de pérovskite bidimensionnel présente une formule générale de (A)₂(CH(NH₂)₂)ₙ₋₁PbₙI₃ₙ₊₁, sachant que A est (CH₃)₂NH₂, C₆H₅CH₂NH₃, CHONH₃, NH₄, H₃NCH₂CH₂CH₂NH₃ ou H₃NCH₂CH₂CH₂CH₂NH₃ ; et sachant que n = 3, 5, 7, 9, 11.

2. Le matériau de pérovskite bidimensionnel à haute solidité selon la revendication 1, sachant que n = 9.

3. Utilisation du matériau de pérovskite bidimensionnel à haute solidité selon l'une quelconque des revendications 1 à 2 dans la fabrication d'une cellule solaire de pérovskite.

4. Utilisation selon la revendication 3, sachant que la cellule solaire de pérovskite fabriquée présente une baisse d'efficacité de moins de 0,5 % lorsqu'elle est exposée à un état d'humidité de plus de 90 % pendant plus de 20 jours.
